**Europäisches Patentamt**

**European Patent Office**

**Office européen des brevets**

(19)

(11) Publication number: **0 213 647**
**B1**

(12)

# EUROPEAN PATENT SPECIFICATION

(45) Date of publication of the patent specification:
**11.10.89**

(51) Int. Cl.⁴: **H03D 13/00**

(21) Application number: **86201067.5**

(22) Date of filing: **19.06.86**

(54) **Phase detector.**

(30) Priority: **01.07.85 NL 8501887**

(43) Date of publication of application:
**11.03.87 Bulletin 87/11**

(45) Publication of the grant of the patent:
**11.10.89 Bulletin 89/41**

(84) Designated Contracting States:
**AT BE CH DE FR GB IT LI NL SE**

(56) References cited:
**EP-A- 0 010 959**
**EP-A- 0 054 322**

(73) Proprietor: **Océ-Nederland B.V., St. Urbanusweg 43,
NL-5914 CC Venlo(NL)**

(72) Inventor: **Simons, Johannes Mathieu Marie, Graaf
Hendrik van de Bergstraat 29, NL-5923 CD Venlo(NL)**

(74) Representative: **Hanneman, Henri W.A.M. et al,
Océ-Nederland B.V. Patents and Information
Postbus 101, NL-5900 MA Venlo(NL)**

ACTORUM AG

## Description

This invention relates to a phase detector for generating a measurement signal indicating the extent to which the actual distance τ between the flanks of data pulses generated for serial data transmission and the detection times determined by a detection clock differs from a required distance Tg, in which phase detector, after detection of a flank of a data pulse, a detection signal phase is generated whose pulse width corresponds to the said actual distance τ, for which purpose the phase detector is provided with a first D-flipflop controlled by the detection clock and an exclusive OR-gate, the data pulses being fed to the D-input of the first flipflop and the the the first input of the exclusive OR-gate, while the output signal of the D-flipflop functioning as detected data is fed to the second input of the exclusive OR-gate, and the detection signal is generated at the output of the exclusive OR-gate, in which phase detector, again after detection of a flank of a data pulse, by means of a second D-flipflop, a reference signal pulse is generated whose pulse width is derived from the detection signal, which width is a measure of the required distance (Tg), and in which phase detector the difference between the detection signal and the reference signal is determined by means of a subtraction circuit in order to generate the measurement signal.

A phase detector of this kind is known from European patent application No. EP-A 0 0 54 322.

In the known phase detector, a reference pulse is delivered whose width is equal to half the clock cycle time. The reference signal is fed to a controlled current source, which current source generates a first current. The detection signal is also fed to a second controlled current source, which generates a second current whose value is equal to the first current. The first current is subtracted from the second current and the differential current is a measure of the difference between the actual distance and the required distance. For the purpose of generation of the reference signal the output of the first flipflop is connected to the input of the second flipflop.

The second flipflop is controlled by a clock signal 180° phase-shifted with respect to the phase of the clock signal of the control for the first flipflop. Thus over a period equal to half the cycle time of the clock signal the second flipflop output signal is shifted with respect to the first flipflop output signal. Both the output of the first flipflop and the output of the second flipflop are fed to an exclusive OR-gate, which generates a reference pulse at each flank of a data pulse. The width of the reference pulse depends on the clock signal duty-cycle. In the case of a reference signal pulse width equal to half the cycle time of a clock signal a duty-cycle of 50% is required.

The object of the invention is to provide a phase detector whose proper operation is independent of the duty-cycle of the clock signal supplied.

In a phase detector according to the invention, this object is attained in that the D-input of the second flipflop is connected to the output of the exclusive OR-gate, in that the clock inputs of the first flipflop and second flipflop are directly interconnected, in that the output signal of the second flipflop functions as a reference signal, and in that the phase detector is provided with at least one adjustment circuit, by means of which the amplitude of the detection signal and/or of the reference signal is/are so adjusted before the signals are fed to the subtraction circuit that the ratio between the amplitude of the reference signal and the amplitude of the detection signal after adjustment is equal to Tg/T.

In the phase detector according to the invention, in response to a data pulse flank, a reference signal of a width equal to the clock signal cycle time is always fed to the output of the second flipflop. Before the reference signal and the detection signal are fed to the subtraction circuit they are so adjusted that the average value of the output signal is equal to 0 if the difference between the actual distance τ and the required distance is equal to 0. The flipflop for determining the reference pulse is controlled by the same clock signal as the first flipflop, so that proper operation of the phase detector is obtained irrespective of the clock signal duty-cylce. Also, the second exclusive OR-gate used in the prior art phase detector has become superfluous for generation of the reference pulse.

The invention will be explained in detail from an exemplified embodiment with reference to Figs. 1 to 6, in which:

Fig. 1 is a diagram of a generally known-phase-lock-loop circuit (PLL) with an arbitrary phase detector,

Fig. 2 is a diagram of a phase detector in which phase information is derived from two consecutive flanks of the data,

Fig. 3 is a time diagram of some of the signals occurring in the phase detector of Fig. 2,

Fig. 4 is a diagram of the phase detector according to the invention,

Fig. 5 is a time diagram of some of the signals occurring in the phase detector of Fig. 4, and

Fig. 6a and 6b are diagrams of one practical embodiment of the phase detector of Fig. 4.

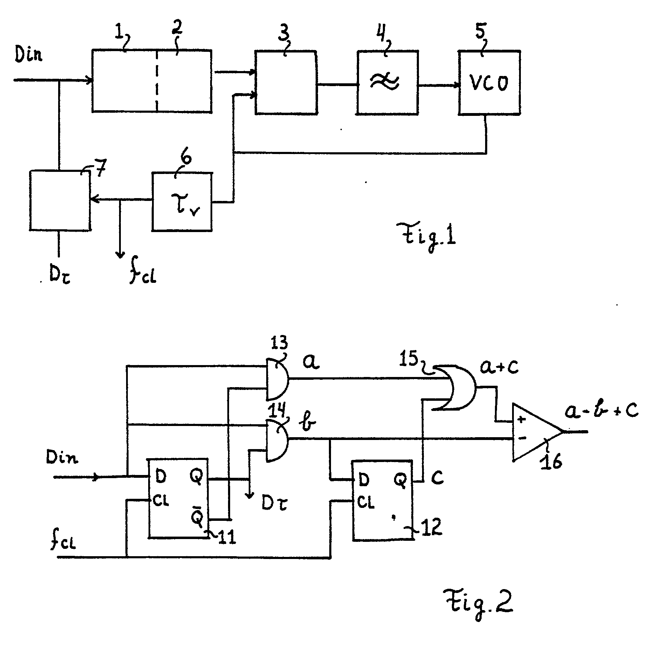

Referring to Fig. 1, the data input signal $D_{in}$ is fed to a flank detector circuit 1 which delivers a signal pulse if a flank is detected. The signal is then fed to a one-shot circuit 2. In a multiplier acting as phase detection element 3 the phase of the date signal is compared with the regenerated clock originating from the oscillator 5. The control voltage obtained from this phase detection element is fed via the loop filter 4 to the voltage controlled oscillator (VCO) 5 which is tuned to the clock frequency. An extra (adjustable) delay circuit 6 is often required, as a result of the non-linear processing in 1 and the phase detection in 3 and, possibly, as a result of time delays, to position the phase of the regenerated clock $f_{CL}$ in the middle of the bit cell for the purpose of optimum detection of the data in the circuit 7. Since both circuit 1 and circuit 6 are frequency- dependent, frequency deviations may also cause deviations in the detection time.

Fig. 2 represents a phase detector which adjusts the phase of the regenerated clock to the middle of the bit cell by making the distance $\tau_1$ between a flank in the data and the following detection time (positive clock flank) equal to the distance $\tau_2$ between the following flank and the proceding detection time (positive clock flank). This embodiment has two D-type flipflops 11, 12 twoo AND-gates 13, 14, an OR-gate 15 and a differential amplifier 16.

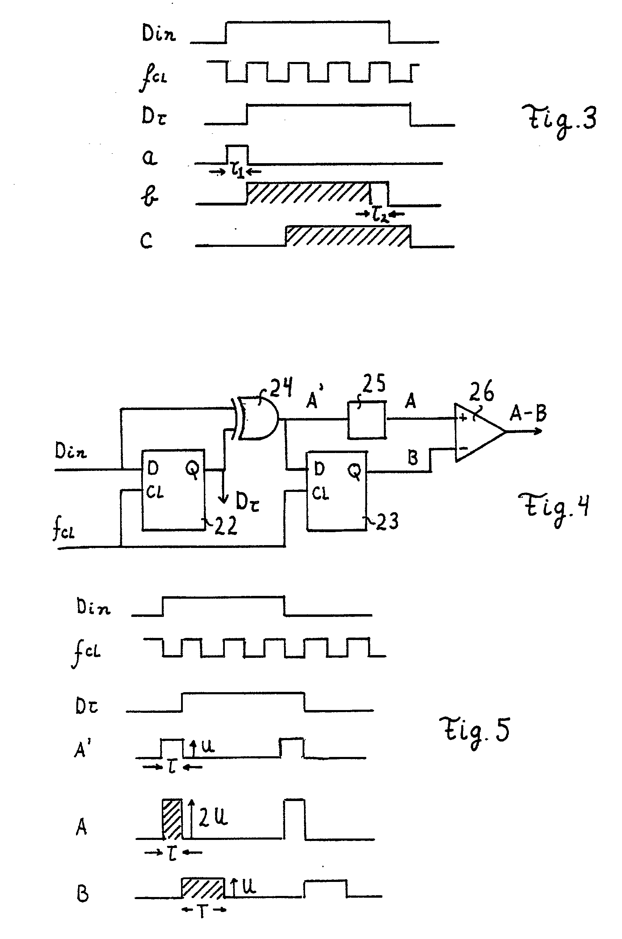

Fig. 3 represents some waveforms of signals occurring in the phase detector of Fig. 2.

The data input signal $D_{in}$ is fed to the D-input of the flipflop 11 and to the AND-gates 13, 14. The clock $f_{CL}$ regenerated by the phase-lock-loop oscillator is fed to the clock input CL of the flipflop 11, and flipflop 12 respectively. The data signal $D_\tau$ to be regarded as the detected data is fed from the Q(set) output of 11 to the AND-gate 14 and the signal inverted with respect to $D_\tau$ is fed from the $\overline{Q}$ (reset) output to the AND-gate 13. The output signal $\underline{b}$ of the AND-gate 14 is fed to the D input of the flipflop 12 and to the minus input of the differential amplifier 16. The Q output signal $\underline{c}$ of the flipflop 12 and the output signal $\underline{a}$ of the AND-gate 13 are fed to the two inputs of the OR-gate 15. The output signal a + c thereof is fed to the plus input of the differential amplifier 16. The output control voltage thereof after low pass filtering is represented by a-b + c = $\tau_1$ -$\tau_2$, since in Fig. 3 on subtraction the hatched areas of b and c cancel one another out. This control voltage is fed to the loop filter. The control is such that $\tau_1$ is made equal to $\tau_2$, in which case the optimum detection time then falls exactly in the middle of the data bit cell. In these conditions the phase information is obtained from two consecutive flanks, i.e. a positive flank and a negative flank, of the data.

Fig. 4 represents the phase detector according to the invention, in which a complete phase measurement is carried out for each flank in the data. According to the invention, the distance $\tau$ between a flank in the data and the following detection time is made equal to half the clock time T. To this end, this phase detector according to the invention always measures both the said distance $\tau$ and the clock cycle time T.

The phase detector in Fig. 4 is constructed of just a few elements, i.e. two D-type flipflops 22, 23, an exclusive OR-gate 24, a factor-2 multiplier 25, and a differential amplifier 26.

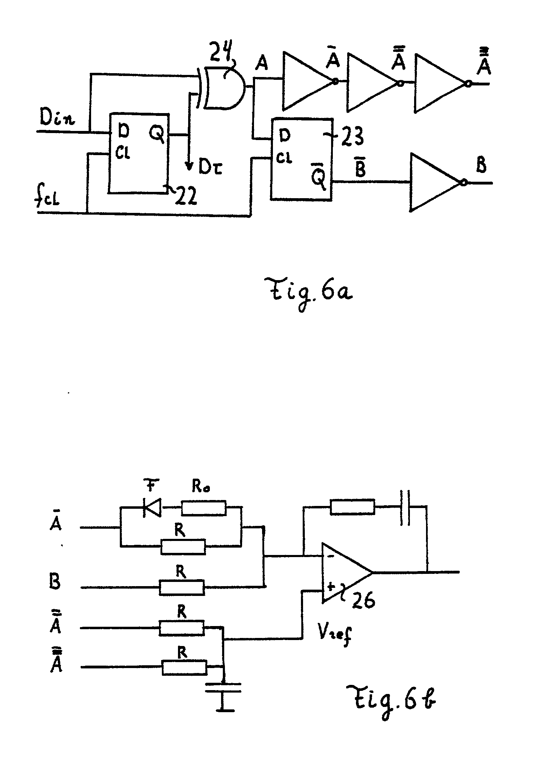

Fig. 5 represents some waveforms of signals occurring in the phase detector of Fig. 4.

The data input signal $D_{in}$ is fed to the D-input of the flipflop 22 and to one input of the exclusive OR-gate 24. This clock $f_{CL}$ regenerated by the loop oscillator is fed to the clock inputs CL of both flipflops 22, 23. The data signal $D_\tau$ taken from the Q(set) output is fed to the other input of the OR-gate 24. The output signal A' thereof is fed to the multiplier 25 and to the D-input of the flipflop 23. The output signal A of multiplier 25 and the output signal B of the Q-output of the flipflop 23 are fed to the plus input, and the minus input respectively of the differential amplier 26.

At each flank in the data there appears at the input of 25 a pulse A' with a width $\tau$ and a height $\underline{u}$. At the output of 23 there then appears a pulse B with a clock cycle width T and height $\underline{u}$. When $\tau = \frac{1}{2}T$ the areas of the two pulses A and B can be made equal by multiplying the pulse A' by 2: $2.u.\tau = u.T$. If $\tau$ deviates, the output of the differential amplifier 26 delivers a control voltage A - B which controls the loop oscillator via the loop filter.

Figs. 6a and 6b represent a practical embodiment of the phase detector illustrated in Fig. 4. To this end, Fig. 6a includes a plurality of inverters used to form the reference voltage $V_{ref}$ and the other input signal A + B for the differential amplifier 26 (see Fig. 6b). Fig. 6b represents how the factor-2 multiplier is constructed by means of a diode F and a resistor $R_0$. This resistor $R_0$ is switched in only during the inverted pulse $\tau$. $R_0$ is smaller than the resistance R of the other resistors as a result of the voltage drop across the diode F during the pulse $\tau$. From the output of the differential amplifier 26 the control voltage is fed to the loop filter.

The advantages of this phase detector according to the invention are the high reliability of data detection and the small number of components required. Despite the presence of noise or jitter on the flanks, optimum detection is at all times obtained in the middle of the data bit cell, optimum use being made of the clock information present in the data and a complete phase measurement is carried out at each flank in the data. The lock-in range of the phase-lock-loop is also improved, i.e. the loop oscillator can have a somewhat greater relative deviation in frequency and yet the loop can still lock. At the same time the risk of false locking is reduced.

Apart from data transmission, this phase detector can also be used for data processing requiring bit synchronization, such as for data storage.

**Claims**

1. A phase detector for generating a measurement signal indicating the extent to which the actual distance $\tau$ between the flanks of data pulses generated for serial data transmission and the detection times determined by a detection clock differs from a required distance (Tg), in which phase detector, after detection of a flank of a data pulse, a detection signal pulse is generated whose pulse width corresponds to the said actual distance , for which purpose the phase detector is provided with a first D-flipflop (22) controlled by the detection clock and an exclusive OR-gate (24), the data pulses being fed to the D-input of the first flipflop (22) and to the first input of the exclusive OR-gate (24), while the output signal ($D_\tau$) of the D-flipflop (22) functioning as detected data is fed to the second input of the exclusive OR-gate (24), and the detection signal (A) is generated at the output of the exclusive OR-gate (24), in which phase detector, again after detection of a flank of a data pulse, by means of a second D-flipflop (23), a reference signal pulse (B) is generated whose pulse width is derived from the detection signal (A), which width is a measure of the required distance Tg, and in which phase detector the difference between the detection signal (A) and the reference signal (B) is determined by means of a subtraction circuit (26) in order to generate the measurement signal, characterised in that
- the D-input of the second flipflop (23) is connected to the output of the exclusive OR-gate (24),
- the clock inputs of the first flipflop (22) and second flipflop (23) are directly interconnected,
- the output signal (B) of the second flipflop (23) functions as a reference signal,
- the phase detector is provided with at least one adjustment circuit (25), by means of which the amplitude of the detection signal (A) and/or of the reference signal (B) is/are so adjusted before the signals are fed to the subtraction circuit (26) that the ratio between the amplitude of the reference signal (B) and the amplitude of the detection signal (A) after adjustment is equal to Tg/T, where T is equal to the clock period.

## Patentansprüche

1. Phasendetektor zum Erzeugen eines Messsignals, das den Betrag angibt, um den der tatsächliche Abstand $\tau$ zwischen den Flanken von Datenimpulsen, die für die Daten-Serieübertragung erzeugt wurden, und den Erkennungszeiten, die von einem Erkennungstakt bestimmt werden, von einem geforderten Abstand (Tg) abweicht, in welchem Phasendetektor nach dem Erkennen einer Flanke eines Datenimpulses ein Erkennungssignalimpuls erzeugt wird, dessen Impulsbreite dem genannten tatsächlichen Abstand $\tau$ entspricht, zu welchem Zweck der Phasendetektor einen ersten D-Flipflop (22) aufweist, der von dem Erkennungstakt gesteuert wird, und ein exklusives OR-Gate (24), wobei die Datenimpulse an den D-Eingang des ersten Flipflops (22) und an den ersten Eingang des exklusiven OR-Gate (24) geleitet werden, während das Ausgangssignal (D$\tau$) des D-Flipflops (22), das als erkannter Datenimpuls wirkt, an den zweiten Eingang des exklusiven OR-Gate (24) geleitet wird, und das Erkennungssignal (A) am Ausgang des exklusiven OR-Gate (24) erzeugt wird, in welchem Phasendetektor wiederum nach dem Erkennen einer Flanke eines Datenimpulses mittels eines zweiten D-Flipflops (23) ein Referenzsignalimpuls (B) erzeugt wird, dessen Impulsbreite vom Erkennungssignal (A) hergeleitet wird, welche Breite ein Mass für den geforderten Abstand Tg ist und in welchem Phasendetektor die Differenz zwischen dem Erkennungssignal (A) und dem Referenzsignal (B) mittels eines Subtraktionskreises (26) bestimmt wird, um das Messsignal zu erzeugen, dadurch gekennzeichnet, dass der D-Eingang des zweiten Flipflops (23) mit dem Ausgang des exklusiven OR-Gate (24) verbunden ist, dass die Takteingänge des ersten Flipflops (22) und des zweiten Flipflops (23) direkt miteinander verbunden sind, dass das Ausgangssignal (B) des zweiten Flipflops (23) als Referenzsignal wirkt und dass der Phasendetektor mindestens einen Einstellkreis (25) aufweist, mit dessen Hilfe die Amplitude des Erkennungssignals (A) und/oder des Referenzsignals (B), bevor diese Signale an den Subtraktionskreis (26) geleitet werden, derart eingestellt wird/werden, dass das Verhältnis zwischen der Amplitude des Referenzsignals (B) und der Amplitude des Erkennungssignals nach der Einstellung gleich Tg/T ist, wobei T gleich der Taktperiode ist.

## Revendications

1. Détecteur de phase servant à produire un signal de mesure indiquant de combien diffère la distance réelle $\tau$ entre les flancs d'impulsions de données produites pour une transmission de données en série et les instants de détection déterminés par une horloge de détection par rapport à une distance requise (Tg), et dans lequel, après détection d'un flanc d'une impulsion de données, une impulsion formant signal de détection est produite, dont la durée correspond à ladite distance réelle $\tau$, le détecteur de phase étant pourvu à cet effet d' une première bascule bistable de type D (22) commandée par l'horloge de détection et une porte OU-Exclusif (24), les impulsions de données étant envoyées à l'entrée D de la première bascule bistable (22) et à la première entrée de la porte OU-Exclusif (24), tandis que le signal de sortie (D$\tau$) de la bascule bistable de type D (22) utilisé en tant que donnée détectée, est envoyé à la seconde entrée de la porte OU-Exclusif (24), et que le signal de détection (A) est produit sur la sortie de la porte OU-Exclusif (24), et dans lequel, après détection d'un flanc d'une impulsion de données, au moyen d'une seconde bascule bistable de type D (23), une impulsion (B) formant signal de référence est produite, dont la durée est dérivée du signal de détection (A) et constitue une mesure de la distance requise Tg, et dans lequel la différence entre le signal de détection (A) et le signal de référence (B) est déterminée au moyen d'un circuit soustracteur (26) servant à produire le signal de mesure, caractérisé en ce que
– l'entrée D de la seconde bascule bistable (23) est accordée à la sortie de la porte OU-Exclusif (24),
– les entrées du signal d'horloge de la première bascule bistable (22) et de la seconde bascule bistable (23) sont interconnectées directement,
– le signal de sortie (B) de la seconde bascule bistable (23) agit en tant que signal de référence,
– le détecteur de phase comporte au moins un circuit de réglage (25), à l'aide duquel l'amplitude du signal de détection (A) et/ou l'amplitude du signal de référence (B) est/sont réglée(s) avant que les signaux soient envoyés au circuit soustracteur (26), de manière que le rapport entre l'amplitude du signal de référence (B) et l'amplitude du signal de détection (A) après le réglage soit égal à Tg/T, T étant égal à la période des impulsions d'horloge.

EP 0 213 647 B1

Fig.1

Fig.2

Fig. 3

Fig. 4

Fig. 5

Fig. 6a

Fig. 6b